# DEMANDE DE BREVET EUROPEEN

(11) **EP 2 372 913 A1**
(43) Date de publication de la demande: **05.10.2011**
(21) Numéro de dépôt: 11160523.4
(22) Date de dépôt: 30.03.2011
(51) Int. Cl.: H03K 17/0812

(54) **Protection d'un équipement électronique**

(30) Priorité: 02.04.2010 FR 1001393
(71) Demandeur: Thales, 92200 Neuilly Sur Seine (FR)
(72) Inventeur: Robert, François, 37390 Chanceaux sur Choisille (FR)
(74) Mandataire: Collet, Alain

(57) **Abrégé**

L'invention concerne la protection d'un équipement électronique contre d'éventuelles surtensions appliquées à ses bornes et plus précisément à une borne de sortie (10) de l'équipement comprenant en outre un interrupteur électronique (M1) raccordé entre la borne de sortie (10) et une masse (12) de l'équipement (11) et des moyens de protection de l'interrupteur électronique contre d'éventuelles surtensions appliquées à la borne de sortie (10). Selon l'invention, les moyens de protection (14) comprennent des moyens de détection d'un courant (R8) supérieur à un seuil donné circulant dans l'interrupteur électronique (M1) et des moyens pour interdire la fermeture de l'interrupteur électronique (M1) lorsque le courant circulant dans l'interrupteur électronique (M1) est supérieur au seuil donné.

## Description

L'invention concerne la protection d'un équipement électronique contre d'éventuelles surtensions appliquées à ses bornes et plus précisément à une borne de sortie de l'équipement. On entend par borne de sortie, une borne sur laquelle une information est délivrée vers l'extérieur de l'équipement. L'invention trouve une utilité particulière dans les équipements électroniques, comme par exemple des équipements embarqués à bord d'aéronefs, susceptibles d'être soumis à la foudre ou à des tensions d'alimentation pouvant être appliquées de façon intempestives à la borne de sortie.

Par exemple, à bord d'aéronefs, des réseaux courants d'alimentation délivrent des tensions continues 28V ou alternatives 115V à une fréquence de 400 Hz. L'application de telles tensions directement sur une borne de sortie tend à détruire les composants de l'équipement associés à cette borne. Cette application peut être due à une défaillance d'un autre équipement destiné à dialoguer avec l'équipement au travers de la borne de sortie.

Actuellement la protection de la borne de sortie est assurée au moyen d'une diode, appelée diode parafoudre, reliée entre la borne de sortie et une masse électrique de l'équipement ainsi que d'un fusible relié en série entre la borne de sortie et les composants de l'équipement associés à cette borne. Cette protection est efficace et évite la destruction des composants. Néanmoins, en cas de surtension, le fusible et la diode sont généralement détruit et nécessite une intervention sur l'équipement. De plus, le test d'une diode parafoudre ne peut se faire sans application d'une onde de tension calibrée sur la diode. Cette application est délicate et ne peut être réalisée sans dépose de l'équipement lors d'une opération de maintenance. Dans le domaine des équipements embarqués à bord d'aéronefs, des opérations de maintenances sont prévues avec une occurrence de plusieurs milliers d'heures. On peut donc se trouver dans une situation où la diode parafoudre est hors service sans possibilité d'en être informé. Par ailleurs, en cas de doute sur le fonctionnement de la diode parafoudre, on est obligé de déposer l'équipement pour effectuer le test de la diode, ce qui nécessite le remplacement de l'équipement pour ne pas immobiliser l'aéronef. Ce remplacement entraine des coûts importants.

L'invention vise à pallier tout ou partie des problèmes cités plus haut en proposant une nouvelle façon de protéger une borne de sortie d'un équipement électronique en évitant l'utilisation d'un fusible et d'une diode parafoudre associés à la borne de sortie.

A cet effet, l'invention a pour objet un équipement électronique comprenant une borne de sortie, un interrupteur électronique raccordé entre la borne de sortie et une masse de l'équipement et des moyens de protection de l'interrupteur électronique contre d'éventuelles surtensions appliquées à la borne de sortie, caractérisé en ce que les moyens de protection comprennent des moyens de détection d'un courant supérieur à un seuil donné circulant dans l'interrupteur électronique et des moyens pour interdire la fermeture de l'interrupteur électronique lorsque le courant circulant dans l'interrupteur électronique est supérieur au seuil donné.

Avantageusement, les moyens de protection comprennent des moyens pour autoriser la fermeture de l'interrupteur électronique après une durée donnée suivant une interdiction. Cette durée est fixe et commence au début de l'interdiction.

L'invention permet le test fréquent des moyens de protection de l'interrupteur électronique sans nécessité la dépose de l'équipement par exemple en simulant un courant supérieur au seuil donné. Cette opération de test peut par exemple être effectuée à chaque mise sous tension de l'équipement ou même sur simple requête d'un opérateur, par exemple en cas de doute sur le fait qu'une surtension soit intervenue.

Un autre avantage de l'invention est d'éviter l'utilisation d'un fusible. De ce fait, aucune intervention pour changer le fusible n'est nécessaire après l'apparition d'une surtension.

L'invention sera mieux comprise et d'autres avantages apparaîtront à la lecture de la description détaillée d'un mode de réalisation donné à titre d'exemple, description illustrée par le dessin joint dans lequel :
la figure 1 représente un exemple de schéma de principe mettant en oeuvre de l'invention ;
la figure 2 représente un schéma plus complet mettant en oeuvre l'invention.

Par souci de clarté, les mêmes éléments porteront les mêmes repères dans les différentes figures.

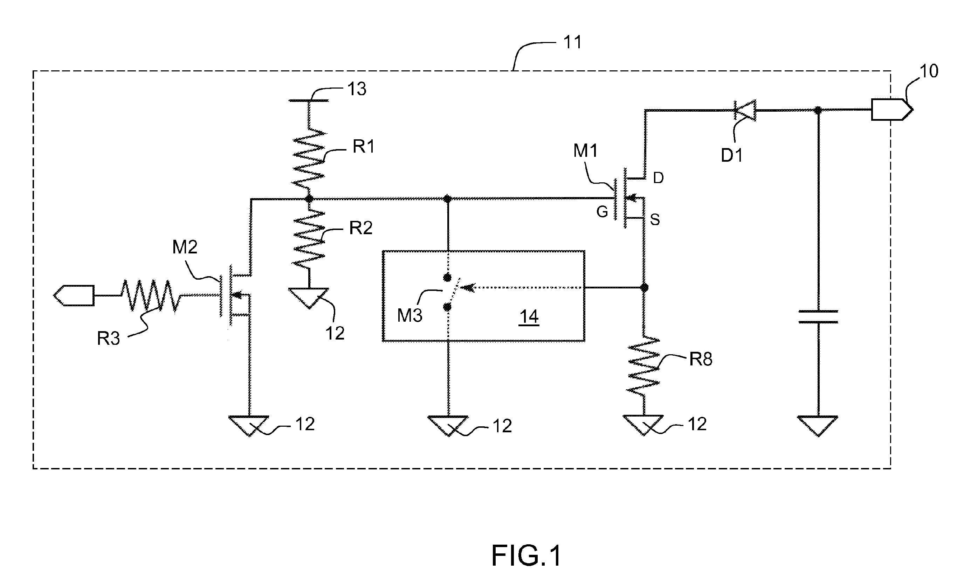

La figure 1 représente des composants associés à une borne de sortie 10 d'un équipement électronique 11. En fonctionnement normal, c'est-à-dire en l'absence de toute surtension, la borne de sortie 10 peut être soit raccordée à une masse 12 de l'équipement 11 soit isolée. Le raccordement à la masse 12 se fait au moyen d'un interrupteur électronique M1 formé, par exemple, par un transistor à effet de champ à canal négatif. Le drain, noté D, du transistor M1 est relié à la borne 10 par l'intermédiaire d'une diode D1 permettant de n'autoriser la circulation du courant que de la borne 10 vers la masse 12. La source, notée S, du transistor M1 est reliée à la masse 12 par l'intermédiaire d'une résistance R8 permettant la mesure de courant circulant dans l'interrupteur électronique M1 entre son drain D et sa source S.

L'interrupteur électronique M1 et commandé par sa grille, notée G. Plus précisément, lorsque la tension entre grille G et source S du transistor M1 a une valeur basse, l'interrupteur électronique est ouvert. Autrement dit le transistor M1 est bloqué. Lorsque la tension entre grille G et source S du transistor M1 a une valeur haute, l'interrupteur électronique est fermé. Autrement dit le transistor M1 est passant.

En fonctionnement normal, pour délivrer une information à la borne de sortie 10, la grille G du transistor M1 est commandée par un second interrupteur électronique, par exemple formé par un transistor à effet de champ à canal négatif M2, permettant de raccorder ou non la grille G du transistor M1 à la masse 12. Lorsque le second interrupteur M2 est ouvert la tension de grille G du transistor M1 est à une valeur haute de tension qui est par exemple fixée par un diviseur de tension formé par deux résistances R1 et R2. La résistance R1 est reliée entre une tension d'alimentation positive 13 de l'équipement 11 et la grille G du transistor M1. La résistance R2 est reliée entre la grille G du transistor M1 et la masse 12. Pour cette valeur haute de tension de grille G, le transistor M1 est passant.

Lorsque le transistor M2 conduit, la tension de grille G du transistor M1 est basse. Cette tension est voisine de celle de la masse 12. Pour cette valeur basse de tension de grille G, le transistor M1 est bloqué.

Le transistor M2 est par exemple piloté par sa grille par l'intermédiaire d'une résistance R3 au moyen d'un circuit logique programmable non représenté sur la figure 1.

On a vu plus haut que la résistance R8 permet la mesure du courant circulant dans l'interrupteur M1 entre son drain D et sa source S. Le point commun du transistor M1 et de la résistance R8, c'est-à-dire la source S du transistor M1, permet de piloter des moyens de protection 14 de l'interrupteur M1. Les moyens de protection 14 comprennent un troisième interrupteur M3 permettant de connecter la grille G du transistor M1 à la masse 12 en cas de surtension apparaissant au niveau de la borne de sortie 10. Plus précisément, une surtension présente sur la borne de sortie 10 lorsque l'interrupteur M1 est fermé fait monter la tension aux bornes de la résistance R8. La comparaison de cette tension avec un seuil prédéfini permet de commander l'interrupteur M3. Tant que la tension aux bornes de la résistance R8 reste inférieure au seuil prédéfini, l'interrupteur M3 reste ouvert et le transistor M1 est piloté par le transistor M2. En revanche si la tension aux bornes de la résistance R8 s'élève au-delà du seuil, l'interrupteur M3 se ferme et force le blocage du transistor M1. La mesure de courant circulant dans la résistance R8 n'intervient que lorsque le transistor M1 conduit. Lorsque le transistor M2 bloque le transistor M1, la mesure de courant circulant dans la résistance R8 n'est pas effectuée. Cette absence de mesure n'a pas de conséquence car, une fois bloqué, le transistor M1 n'est pas sensible à une éventuelle surtension.

Le fait d'utiliser la résistance R8, placée entre la source S du transistor M1 et la masse 12, pour mesurer le courant circulant dans l'interrupteur M1 permet, au moment de l'apparition d'une surtension sur la borne 10, de faire monter le potentiel présent à la source S du transistor à effet de champ M1. Cette augmentation de potentiel réduit la différence de potentiel entre la grille G et la source S du transistor M1, ce qui augmente la résistance interne du transistor M1 entre son drain D et sa source S. Cette baisse de conduction du transistor M1 constitue une première protection du transistor M1. Cette protection reste partielle et est insuffisante pour ouvrir complètement l'interrupteur M1. L'ouverture complète est obtenue au moyen de l'interrupteur M3.

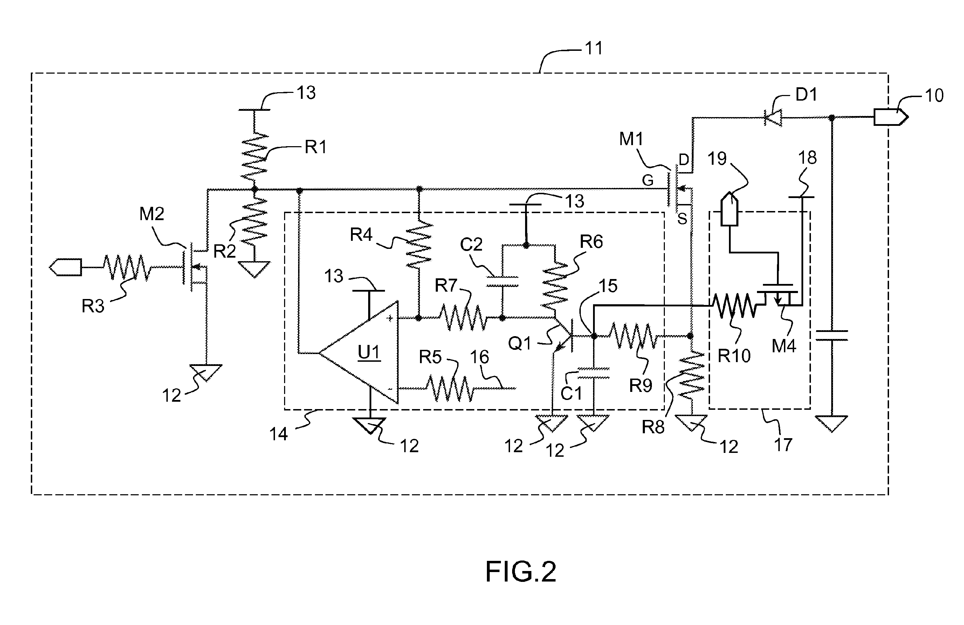

La figure 2 représente un schéma plus complet mettant en oeuvre l'invention. On retrouve les transistors M1 et M2, la diode D1, le pont diviseur formé par les résistances R1 et R2 et les résistances R3 et R8. Un exemple de réalisation des moyens de protection 14 est représenté plus en détail sur la figure 2. Les moyens de protection 14 comprennent un filtre passe bas permettant de filtrer la détection du courant circulant dans l'interrupteur électronique M1 afin d'éviter que des surtensions de trop faible durée ne viennent interdire la fermeture de l'interrupteur électronique M1. Le filtre passe bas comprend par exemple une résistance R9 et un condensateur C1 raccordés en série entre la source S du transistor M1 et la masse 12. Un point commun 15 de la résistance R9 et du condensateur C1 forme la sortie du filtre passe bas.

La tension présente au point 15 est inversée et amplifiée au moyen d'un transistor bipolaire Q1 dont la base est raccordée au point 15, l'émetteur à la masse 12 et le collecteur à la tension d'alimentation positive 13 par l'intermédiaire d'une résistance R6 et d'un condensateur C2 montés en parallèle.

Le collecteur du transistor Q1 est raccordé à une entrée positive d'un comparateur U1 par l'intermédiaire d'une résistance R7. L'entrée positive du comparateur U1 est par ailleurs raccordée à la grille du transistor M1 par l'intermédiaire d'une résistance R4. Une entrée négative du comparateur U1 est raccordé à une tension de référence 16 par l'intermédiaire d'une résistance R5. La tension de référence 16 forme un seuil permettant de définir le courant maximum circulant dans la résistance R8 au-delà duquel il est nécessaire de forcer le blocage du transistor M1 pour assurer sa protection.

La sortie du comparateur U1 est raccordée à la grille G du transistor M1. La sortie du comparateur M1 est soit ouverte soit reliée à la masse en fonction de la différence de potentiel entre ses entrées positive et négative. Ce type de comparateur est connu dans la littérature anglo-saxonne sous le nom de « open/ground ». Le comparateur U1 forme l'interrupteur M3 représenté sur la figure 1. Le comparateur U1 compare une image de la tension aux bornes de la résistance R8 à la tension de référence 16. L'image de la tension aux bornes de la résistance R8 est la tension présente au niveau du collecteur du transistor Q1, La sortie du comparateur U1 est soit ouverte soit reliée à la masse en fonction du résultat de la comparaison entre l'image de la tension aux bornes de la résistance R8 et la tension de référence 16.

Plus précisément, Lorsque la courant circulant dans la source S du transistor M1 reste inférieure au seuil tolérable pour ce transistor, autrement dit lorsque la tension aux bornes de la résistance R8 reste inférieure à une valeur donnée, le transistor Q1 est bloqué, le potentiel de l'entrée positive du comparateur U1 reste supérieure à la tension de référence 16 présente sur l'entrée négative du comparateur U1 et la sortie du comparateur U1 est à l'état ouvert. Dans ce cas, le transistor M1 peut être normalement piloté par le transistor M2.

Dans le cas contraire, lorsque le courant circulant dans la résistance R8 devient supérieur au seuil tolérable pour le transistor M1, le transistor Q1 devient passant, le potentiel de l'entrée positive du comparateur U1 devient inférieur à la tension de référence 16 présente sur l'entrée négative du comparateur U1, la tension présente sur la sortie du comparateur U1 est voisine de celle de la masse 12, ce qui force la tension de grille G du transistor M1 à la tension de la masse 12.

Lorsque la tension de grille G du transistor M1 est forcée à la masse 12, le courant circulant dans la résistance R8 disparait ce qui interrompt le forçage à la masse de la grille G du transistor M1. Pour éviter une interruption trop rapide du forçage, les moyens de protection comprennent avantageusement des moyens pour autoriser la fermeture de l'interrupteur électronique M1, c'est-à-dire interrompre le forçage, après une durée donnée suivant une interdiction. Cette durée donnée commence à l'instant où débute l'interdiction. La durée donnée est fixe. Elle est définie au moyen de composants passifs et plus précisément au moyen de la valeur du condensateur C2 en lien avec les valeurs des résistances R4, R6 et R7 qui permettent de temporiser le retour à l'état normal de l'équipement, c'est-à-dire sans forçage de la grille G du transistor M1.

Avantageusement, l'équipement 11 comprend des moyens de test 17 des moyens de protection 14. Les moyens de test 17 permettent de forcer l'image de la tension aux bornes de la résistance R8 à une valeur obtenue en cas de surtension appliquée à la borne de sortie 10.

Les moyens de test 17 permettent de porter le potentiel de base du transistor bipolaire Q1 à une tension suffisante pour le mettre en conduction indépendamment du courant circulant dans la résistance R8 et donc sans faire appel à une surtension sur la borne 10. Les moyens de test 17 comprennent par exemple un transistor M4 à effet de champ à canal positif dont le drain est raccordé au point 15 par l'intermédiaire d'une résistance R10, dont la source est raccordée à une source de tension 18 qui peut être utilisée pour des applications logiques de l'équipement électronique 11, comme par exemple une source de tension de 3,3V. La grille du transistor M4 est raccordée à une borne 19 d'un circuit logique pouvant délivrer soit une tension de 3,3V soit une tension de 0V. De façon plus générale, le transistor M4 forme un interrupteur électronique permettant de forcer la mise en conduction du transistor bipolaire Q1.

Lorsque l'on ne souhaite pas effectuer de test des moyens de protection 14, une tension logique de 3,3V est appliquée à la grille du transistor M4 et ouvre celui-ci. La tension du point 15 est alors uniquement formée au travers de la résistance R9 et seule une surtension appliquée à la borne 10 peut mettre en conduction le transistor Q1.

En revanche, lorsque l'on souhaite effectuer un test des moyens de protection 14, on applique à la grille du transistor M4 une tension logique nulle et le transistor M4 devient passant. Il permet d'appliquer au point 15 la tension de la source 18 au travers de la résistance R9, ce qui force la mise en conduction du transistor Q1 et porte la tension de grille du transistor M1 à la masse 12 par l'intermédiaire du comparateur U1.

## Revendications

1. Equipement électronique comprenant une borne de sortie (10), un interrupteur électronique (M1) raccordé entre la borne de sortie (10) et une masse (12) de l'équipement (11) et des moyens de protection de l'interrupteur électronique contre d'éventuelles surtensions appliquées à la borne de sortie (10), **caractérisé en ce que** les moyens de protection (14) comprennent des moyens de détection d'un courant (R8) supérieur à un seuil donné circulant dans l'interrupteur électronique (M1), des moyens pour interdire la fermeture de l'interrupteur électronique (M1) lorsque le courant circulant dans l'interrupteur électronique (M1) est supérieur au seuil donné et des moyens (C2, R4, R6, R7) pour autoriser la fermeture de l'interrupteur électronique (M1) après une durée donnée suivant une interdiction.

2. Equipement selon la revendication 1, **caractérisé en ce que** les moyens de protection (14) comprennent un filtre passe bas (R9, C1) permettant de filtrer la détection du courant circulant dans l'interrupteur électronique (M1) afin d'éviter que des surtensions de trop faible durée ne viennent interdire la fermeture de l'interrupteur électronique M1.

3. Equipement selon l'une des revendications précédentes, **caractérisé en ce que** l'interrupteur électronique (M1) est un transistor à effet de champ à canal négatif raccordé à la borne de sortie (10) par son drain (D) et à la masse (12) de l'équipement (11) par sa source (S), et commandé par sa grille (G) et **en ce que** les moyens de protection (14) comprennent des moyens de raccordement (U1) de la grille (G) du transistor à effet de champ (M1) à la masse (12) de l'équipement (11).

4. Equipement selon la revendication 3, **caractérisé en ce que** les moyens de détection d'un courant comprennent une résistance (R8) reliée entre la source (S) du transistor à effet de champ (M1) et la masse (12) l'équipement (11) ainsi que des moyens (Q1) pour commander les moyens de raccordement (U1) de la grille (G) du transistor à effet de champ (M1) à la masse (12) de l'équipement (11) lorsque la tension aux bornes de la résistance (R8), formant une image du courant circulant dans l'interrupteur électronique (M1), dépasse une tension correspondant au seuil de courant donné.

5. Equipement selon la revendication 4, **caractérisé en ce que** les moyens (Q1) pour commander les moyens de raccordement (U1) de la grille (G) du transistor à effet de champ (M1) à la masse (12) de l'équipement (11) comprennent un comparateur (U1) comparant une image de la tension aux bornes de la résistance (R8) à une tension de référence (16), et **en ce qu'**une sortie du comparateur (U1) est raccordée à la grille (G) du transistor (M1), la sortie du comparateur (U1) est soit ouverte soit reliée à la masse en fonction du résultat de la comparaison entre l'image de la tension aux bornes de la résistance (R8) et la tension de référence (16).

6. Equipement selon l'une des revendications précédentes, **caractérisé en ce qu'**il comprend des moyens de test (17) des moyens de protection (14).

7. Equipement selon les revendications 5 et 6, **caractérisé en ce que** les moyens de test (17) des moyens de protection (14) permettent de forcer l'image de la tension aux bornes de la résistance (R8) à une valeur obtenue en cas de surtension appliquée à la borne de sortie (10).
